# EUROPÄISCHE PATENTANMELDUNG

(11) **EP 2 031 299 A1**
(43) Veröffentlichungstag der Anmeldung: **04.03.2009**
(21) Anmeldenummer: 08163150.9
(22) Anmeldetag: 28.08.2008
(51) Int. Cl.: F21V 23/00, F21S 8/10, F21Y 101/02

(54) **Vorrichtung zur Anordnung von LED-Leuchten**

(30) Priorität: 31.08.2007 DE 102007041335
(71) Anmelder: Siemens AG Österreich, 1210 Wien (AT)
(72) Erfinder: Egger, Rainer, 1220 Wien (AT); Ganal, Emmanuel, 1160 Wien (AT); Hellinger, Leopold, 3710 Ziersdorf (AT); Ladenhaufen, Josef, 8350 Fehring (AT); Neumann, Gerhard, 3231 St. Margarethen (AT); Schnatter, Gottfried, 2100 Leobendorf (AT)
(74) Vertreter: Maier, Daniel Oliver

(57) **Zusammenfassung**

Vorrichtung zur Anordnung von LED-Leuchten (5), umfassend eine Leiterplatte (1) und eine auf dieser anordenbare beliebige Anzahl an LED-Leuchten (5) sowie eine mit der Leiterplatte (1) in Verbindung stehende Steuerplatine (2), wobei die Leiterplatte (1) und die Steuerplatine (2) auf einer Kunststoffträgervorrichtung (4) angebracht sind und die Steuerplatine (2) über eine Steckvorrichtung (10) an eine elektrische Energiequelle angeschlossen ist. Erfindungsgemäß ist es vorgesehen, dass die Leiterplatte (1) einstückig mit der Steuerplatine (2) gefertigt und als biegeplastische Trägerplatte (3), vorzugsweise aus kupferkaschiertem EpoxidGlashartgewebe ausgeführt ist. Durch den Einsatz einer derartigen Trägerplatte (3) ergibt sich eine Einsparung von Bauteilen sowie eine einfachere Fertigungs- und Montagemöglichkeit.

## Beschreibung

### Technisches Gebiet

Die Erfindung bezieht sich auf eine Vorrichtung zur Anordnung von LED-Leuchten, umfassend eine Leiterplatte und eine auf dieser anordenbare beliebige Anzahl an LED-Leuchten sowie eine mit der Leiterplatte in Verbindung stehende Steuerplatine, wobei die Leiterplatte und die Steuerplatine auf einer Kunststoffträgervorrichtung angebracht sind und die Steuerplatine über eine Steckvorrichtung an eine elektrische Energiequelle angeschlossen ist, gemäß dem Oberbegriff des Anspruchs 1.

### Stand der Technik

Als LEDs (light emitting diodes) bezeichnete HalbleiterBauelemente, welche Licht abstrahlen, sobald elektrischer Strom in Durchlassrichtung fließt, sind in der Beleuchtungstechnik hinreichend bekannt und ersetzen zunehmend konventionelle Glühleuchten und Leuchtstoffkörper.

Der Einsatz von LED-Leuchten wird vor allem wegen einer gegenüber konventionellen Beleuchtungskörpern besseren Energieeffizienz, einer längeren Lebensdauer, einer schnelleren Reaktionszeit und eines geringeren Platzbedarfs immer populärer.

Insbesondere im Bereich von KFZ-Außen- und Innenbeleuchtungen gibt es starke Bestrebungen, um LED-Leuchten in wirtschaftlicher Weise nutzbar zu machen. Schon bisher fanden LED-Leuchten als Rücklichter und Bremsleuchten von Kraftfahrzeugen Einsatz, aufgrund verbesserter Optiken bzw. einer gesteigerten Lichtabgabe werden LED-Leuchten neuerdings auch als Scheinwerfer im Fahrzeug-Frontbereich eingesetzt.

Da eine einzelne LED-Leuchte gegenüber einer Glühlampe eine vergleichsweise geringe Leuchtdichte aufweist, wird üblicherweise eine zu einem "Array" zusammengefasste Mehrzahl an LED-Leuchten angeordnet. Um ein derartiges Array auszugestalten, werden üblicherweise mehrere LED-Leuchten in einer Matrixanordnung auf einer Leiterplatte (PCB, printed circuit board) montiert, z.B. mittels einer Oberflächenmontagetechnik (SMT, surface mount technology).

Die Leiterplatte weist gedruckte elektrische Schaltungen auf, welche an definierten Stellen Anschlussflächen für die zu montierenden LED-Leuchten aufweisen. Die LED-Leuchten weisen elektrische Kontaktfüße auf, welche in einem an den Anschlussflächen ausgebildeten Sitz eingeführt und dort in einem weiteren Montageschritt verlötet werden. Solcherart sind die LED-Leuchten leitend mit der elektrischen Schaltung verbunden und können mit Strom versorgt werden, welcher über eine geeignete elektrische Energiequelle in die Leiterplatten-Schaltung eingespeist wird.

Gemäß dem Stand der Technik kann es sich bei der Leiterplatte um eine starre Leiterplatte, z.B. vom Typ FR4 handeln. Üblicherweise werden die LED-Leuchten jedoch auf flexible Leiterplatten, welche entsprechend einer vorgegebenen Geometrie gefaltet werden können, bestückt. Derartige flexible Leiterplatten sind aus einem flexiblen Kunststoff hergestellt, beispielsweise aus Polyimidfolien. Hierbei finden bevorzugt "Flexboards" Anwendung, worunter mehrlagige Leiterplatten, die homogen aus einer Mehrzahl an Polyimidträgerfolien aufgebaut sind, verstanden werden.

Bei Polyimid handelt es sich um einen Hochleistungskunststoff mit thermoplastischen Eigenschaften. Polyimidfolien bzw. flexible Leiterplatten sind daher nur unter Wärmeeinwirkung formhaltig biegeverformbar oder faltbar.

Das Bestücken bzw. Verlöten der LED-Leuchten auf den flexiblen Leiterplatten gestaltet sich relativ aufwändig, da aufgrund der weichen Konsistenz der flexiblen Leiterplatten Stützvorrichtungen bzw. Stützrahmen zum Einsatz kommen müssen, welche einen geeigneten Rückhalt der flexiblen Leiterplatten gegenüber der Krafteinwirkung durch eine jeweilige Bestückungsvorrichtung gewährleisten.

Die mit LED-Leuchten bestückte Leiterplatte wird an einer üblicherweise aus Kunststoff gefertigten Trägervorrichtung befestigt.

Um die LED-Leuchtenanordnung der Krümmung eines vorgegebenen Gehäuses bzw. einer die LED-Strahlen bündelnden Linseneinrichtung anzupassen und um eine optimale Ausleuchtung sicherzustellen, sind die Kunststoffträgervorrichtung und die Leiterplatte zumeist gestuft ausgeführt, sodass also einzelne LEDs auf unterschiedlichen Ebenen der Kunststoffträgervorrichtung angeordnet sind.

Als problematischer Faktor erweist sich bei LED-Leuchtenanordnungen die während des LED-Betriebs erzeugte Wärme. Insbesondere bei Kfz-Anwendungen wird zumeist eine relativ dichte Anordnung von LED-Leuchten vorgenommen, um z.B. die Lichtabgabe von Scheinwerfern möglichst zu erhöhen. Analog zur Anzahl bzw. zur Anordnungsdichte der LED-Leuchten steigt jedoch auch die mit der Lichtstrahlung einhergehende Wärmeentwicklung.

Da sich bei zunehmender Temperatur der Wirkungsgrad und auch die Lebensdauer der LED-Leuchten mitunter drastisch vermindern, bedarf es entsprechender Maßnahmen zur Ableitung der erzeugten Wärme.

Zu diesem Zweck werden gemäß dem Stand der Technik metallische Kühlplättchen an der den LED-Leuchten abgewandten Unterseite der Leiterplatte angeordnet. Die jeweils im Bereich der LED-Leuchten an der Leiterplatten-Unterseite platzierten Kühlplättchen bestehen z.B. aus Aluminium oder Kupfer und weisen damit eine hohe Wärmeleitfähigkeit auf. Üblicherweise werden die Kühlkörper mit einem speziellen Wärmeleitklebstoff an der Leiterplatte angeklebt.

Um die Betriebssicherheit der LED-Leuchten zu gewährleisten, wird die mit LED-Leuchten bestückte Leiterplatte mittels einer prozessorbetriebenen Steuereinrichtung, welche eine geeignete Treiberschaltung aufweist, angesteuert. Diese ist erforderlich, da die Versorgungsspannung in einem Kraftfahrzeug-Bordnetz zwischen 9 und 16 Volt schwankt und die LED-Leuchten daher nicht auf sonst übliche Weise mittels eines Vorwiderstandes betreibbar sind. Mittels der Steuereinrichtung kann die Versorgungsspannung und somit auch der durch die LED-Leuchten fließende Strom kontrolliert werden.

Gemäß dem Stand der Technik ist die Steuereinrichtung bzw. die Treiberschaltung auf einer separaten Steuerplatine neben der für die LED-Leuchten vorgesehenen Leiterplatte angeordnet. Bei der Steuerplatine handelt es sich um eine starre Leiterplatte, z.B. um eine auf Epoxidharz-Basis gefertigte FR4-Platte mit einer Querschnittsdicke von 1,5 mm.

Um die LED-Leiterplatte mit der Steuerplatine zu verbinden, ist die LED-Leiterplatte mit einem als "Anschlussschwanz" bezeichneten Kontaktierabschnitt versehen. Die Ausbildung derartiger Kontaktierabschnitte an der LED-Leiterplatte verursacht einen beträchtlichen Materialaufwand und hohe Fertigungskosten.

Auf Seiten der Steuerplatine sind entsprechende Stecker erforderlich, deren Leitungen zum Kontaktierabschnitt der LED-Leiterplatte führen und mit einem Anschlusselement am Kontaktierabschnitt befestigt werden. Die Herstellung und Montage dieser Stecker samt der zuführenden Leitungen und Anschlusselemente gestaltet sich als aufwändig, wobei die erforderlichen Bauteile wertvollen Platz beanspruchen.

### Um die Steuerplatine an die elektrische

Versorgungseinrichtung bzw. an das Bordnetz anzuschließen, weist die Steuerplatine überdies Steckverbinder auf. Auch dies bedingt einen beträchtlichen Bauteilaufwand und Platzbedarf auf der Steuerplatine.

### Darstellung der Erfindung

Es ist daher ein Ziel der vorliegenden Erfindung, eine Vorrichtung zur Anordnung von LED-Leuchten, insbesondere eine LED-Fahrzeugleuchtenanordnung bereitzustellen, welche eine einfachere und wirtschaftlichere Herstellung und Montage erlaubt. Der erforderliche Bauteilaufwand soll verringert und der Platzbedarf der LED-Leuchtenanordnung sowie deren Gewicht sollen minimiert werden.

Insbesondere soll die Anordnung von Kühlplättchen an der Leiterplatte entbehrlich gemacht werden. Hingegen soll eine einfache und effiziente Wärmeabfuhr von den LED-Leuchten ermöglicht werden.

Auch das Anlegen von Stützrahmen an die Leiterplatte während des LED-Bestückungs- und Lötverfahrens soll entfallen können.

Die Leiterplatte soll ohne Wärmeeinwirkung und ohne einer Vorsehung von (für die Leiterbahnen kritischen) Faltkanten an beliebige dreidimensionale Geometrien des Kunststoffträgers dauerhaft angepasst werden können.

Des Weiteren soll auf die Vorsehung einer Steckvorrichtung zwischen Steuerplatine und der LED-Leiterplatte verzichtet werden.

Diese Ziele werden durch eine Vorrichtung zur Anordnung von LED-Leuchten mit den Merkmalen des Anspruchs 1 erreicht. Eine gattungsgemäße Vorrichtung, insbesondere eine LED-Fahrzeugleuchtenanordnung, umfasst eine Leiterplatte und eine auf dieser anordenbare beliebige Anzahl an LED-Leuchten sowie eine mit der Leiterplatte in Verbindung stehende Steuerplatine, wobei die Leiterplatte und die Steuerplatine auf einer Kunststoffträgervorrichtung angebracht sind und die Steuerplatine über eine Steckvorrichtung an eine elektrische Energiequelle angeschlossen ist.

Erfindungsgemäß ist es vorgesehen, dass die Leiterplatte einstückig mit der Steuerplatine gefertigt und als biegeplastische Trägerplatte, vorzugsweise aus kupferkaschiertem Epoxid-Glashartgewebe ausgeführt ist. Bei deratigen biegeplastischen Trägerplatten auf vorzugsweise Epoxid-Glasfaserbasis handelt es sich um eine im Fachjargon auch als Semi-Rigid-Plattenelement bezeichnete Komponente aus der Multilayer-Platinenfertigung, welche an sich zur Überlagerung und festen Verbindung mit einer Mehrzahl weiterer derartiger Platinen-Komponenten vorgesehen ist.

Die biegeplastische Trägerplatte besitzt eine im Wesentlichen homogene Querschnittsdicke, weist also sowohl in jenem als LED-Leiterplatte als auch in jenem als Steuerplatine fungierenden Trägerplatten-Abschnitt im Wesentlichen dieselbe Querschnittsdicke bzw. denselben Schichtaufbau auf. Durch diese einstückige Ausführung der Trägerplatte ergibt sich gegenüber dem aufwändigen Laminieren oder Fräsen flexibler und starrer Leiterplatten unterschiedlichen Querschnitts, so wie bei Starrflex-Leiterplatten bekannt, eine viel einfachere und kostengünstigere Fertigung.

Aufgrund ihrer Biegeplastizität kann die Trägerplatte formhaltig im Kaltbiegeverfahren gebogen und an die jeweilige Geometrie einer vorgesehenen Kunststoffträgervorrichtung angepasst werden.

Einerseits besitzt die Trägerplatte also eine vorteilhafte plastische Biegsamkeit, andererseits weist sie jedoch auch - im Gegensatz zu üblicherweise zur LED-Bestückung eingesetzten flexiblen Leiterplatten - eine ausreichende Starrheit auf, um ein einfaches und sicheres Bestücken und Verlöten von LED-Leuchten an der Trägerplatte zu ermöglichen. Auf einen Einsatz von Stützrahmen, so wie dies bei einer LED-Bestückung von vergleichsweise weichen bzw. elastischen flexiblen Leiterplatten erforderlich ist, kann somit verzichtet werden.

Da die biegeplastische Trägerplatte nach erfolgtem Umformen eine klare Formstabilität aufweist, kann eine in gewünschter Weise vorgeformte Trägerplatte auf eine jeweils dafür vorgesehene Kunststoffträgervorrichtung aufgesetzt und dort befestigt werden.

Durch den Einsatz einer derartigen biegeplastischen Trägerplatte bzw. einem Semi-Rigid-Plattenelement ergibt sich eine stark vereinfachte Fertigung von LED-Anordnungsvorrichtungen und somit ein beträchtlicher Kostenvorteil.

Durch die einstückige Ausführung eines Leiterplatten-Abschnitts und eines Steuerplatinen-Abschnitts der Trägerplatte entfällt die Vorsehung von Steckern, welche bisher eine separat gefertigte (flexible) LED-Leiterplatte mit einer eigenständigen (starren) Steuerplatine verbunden haben und die Fertigung gestaltet sich noch wirtschaftlicher. Auch die bisher an der LED-Leiterplatte vorgesehenen "Anschlussschwänze" zur Verbindung mit der Steuerplatine können entfallen und es ergibt sich eine bedeutende Material-und Platzersparnis.

Da als Basismaterial der biegeplastischen Trägerplatte bevorzugt Glashartgewebe zum Einsatz kommt, also jenes Trägermaterial, welches standardmäßig auch zur Herstellung von Standard-FR4-Leiterplatten zur Anwendung kommt, wird eine besonders günstige Fertigung ermöglicht.

Um ein problemloses Umformen der biegeplatischen Trägerplatte im Kaltbiegeverfahren zu ermöglichen, beträgt die Querschnittsdicke einer aus Glashartgewebe bestehenden dielektrischen Trägerschicht der Trägerplatte vorzugsweise weniger als 220 µm.

In einer besonders bevorzugten Ausführungsweise der biegeplatischen Trägerplatte weist die Querschnittsdicke der dielektrischen Trägerschicht der Trägerplatte ein Maß zwischen 100 und 150 µm auf. Eine derartige Querschnittsdicke hat sich in Versuchen als ideal hinsichtlich der Plastizitäts- und Festigkeitseigenschaften der Trägerplatte herausgestellt.

In einer ersten Ausführungsweise ist die biegeplastische Trägerplatte nur auf ihrer in Montagelage den LED-Leuchten zugewandten bzw. der Kunststoffträgervorrichtung abgewandten Oberseite mit einer Leiterschicht versehen. Eine derartige einfache Leiterschichtkaschierung reicht für einfachere LED-Anwendungen, bei denen nur eine vergleichsweise geringe Wärmeentwicklung auftritt, aus, um die beim LED-Leuchten-Betrieb anfallende Strahlungs- und Konvektionswärme nach oben hin an die Umgebungsluft abzuführen.

Im Falle von Hochleistungs-LEDs, wie sie bei Kfz-Beleuchtungen Einsatz finden, bedarf es jedoch weiterer Maßnahmen zur Abführung der durch die LED-Leuchten entwickelten Wärme. In einer bevorzugten Ausführungsweise der Erfindung ist es daher vorgesehen, dass die Trägerplatte sowohl an ihrer in Montagelage den LED-Leuchten zugewandten Oberseite als auch an ihrer in Montagelage der Kunststoffträgervorrichtung zugewandten Unterseite mit einer Leiterschicht versehen ist, wobei die Trägerplatte in eigens vorgesehenen thermischen Arealen mit vorzugsweise rasterförmig angeordneten wärmeableitenden Durchkontaktierungen, sogenannten "Thermal Vias" versehen ist, welche die beiden Leiterschichten miteinander verbinden.

Indem die Durchkontaktierungen die beiden Leiterschichten und miteinander verbinden, wird ein effizienter Wärmetransport von der den LED-Leuchten zugewandten oberen Leiterschicht zur der Kunststoffträgervorrichtung zugewandten unteren Leiterschicht ermöglicht. Auf das bisher praktizierte Ankleben von Aluminium- bzw. Metallplättchen an der der Kunststoffträgervorrichtung zugewandten Leiterplatten-Unterseite kann somit in Zukunft verzichtet werden.

Um Luftspalten zwischen der Trägerplatte und der Kunststoffträgervorrichtung auszuschließen und einen idealen Wärmeübergang von der unteren Leiterschicht zur Kunststoffträgervorrichtung zu ermöglichen, ist es in einer bevorzugten Ausführungsvariante der Erfindung vorgesehen, dass die Trägerplatte mittels Anpresselementen an die Kunststoffträgervorrichtung angepresst wird.

Um eine ökonomische Fertigung zu ermöglichen, handelt es sich bei diesen Anpresselementen vorzugsweise um einstückig mit der Kunststoffträgervorrichtung gefertigte Kunststoffnieten.

Um eine noch bessere Wärmeabfuhr von den LED-Leuchten zu erzielen, ist die Kunststoffträgervorrichtung in einer weiteren bevorzugten Ausführungsvariante der Erfindung aus wärmeleitendem Kunststoff gefertigt. Die Auswahl bzw. wärmeleitende Einstellung des Kunststoffs kann entsprechend dem im jeweiligen Einsatzgebiet vorliegenden Entwärmungsbedarf vorgenommen werden.

Um ein einfaches Aufstecken der Steckvorrichtungen auf den Steuerplatinen-Abschnitt der biegeplastischen Trägerplatte zu ermöglichen, weist die Kunststoffträgervorrichtung erfindungsgemäß einen Kupplungssteg auf, dessen Stegdicke in Addition mit einer Querschnittsdicke der am Kupplungssteg aufliegenden Trägerplatte samt der Schichtdicke der daran angeordneten Kontaktbahnen im Wesentlichen einer lichten Breite einer Steckeraufnahme der Steckvorrichtung entspricht. Der biegeplastischen Trägerplatte wird also im Bereich der Kontaktbahnen ein vom Kupplungssteg ausgebildeter Sockel geboten, welcher der Trägerplatte in jenem Bereich eine ausreichende Stabilität verleiht, um mit der Steckvorrichtung gekuppelt zu werden.

Eine besonders platzsparende Bauweise der erfindungsgemäßen LED-Anordnungs-Vorrichtung wird ermöglicht, indem ein mit LED-Leuchten bestückter Leiterplatten-Abschnitt der Trägerplatte auf einer Vorderseite der Kunststoffträgervorrichtung angeordnet ist und ein Steuerplatinen-Abschnitt der Trägerplatte auf einer Rückseite der Kunststoffträger-vorrichtung angeordnet ist, wobei der Leiterplatten-Abschnitt und der Steuerplatinen-Abschnitt mittels eines einstückig mit jenen Abschnitten gefertigten und im Wesentlichen um insgesamt 180° (vorzugsweise zwei mal um 90°) umgebogenen Verbindungsabschnitts miteinander verbunden sind.

### Kurzbeschreibung der Zeichnungen

Die Erfindung wird nun anhand eines Ausführungsbeispiels näher erläutert. Dabei zeigt:
- Fig.1: eine erfindungsgemäße Vorrichtung zur Anordnung von LED-Leuchten in Rückansicht
- Fig.2: eine erfindungsgemäße Vorrichtung zur Anordnung von LED-Leuchten in Vorderansicht
- Fig.3: eine Einzeldarstellung einer bereits zum Aufsetzen auf eine Kunststoffträgervorrichtung vorbereiteten biegeplastischen Trägerplatte in Rückansicht
- Fig.4: eine Einzeldarstellung einer bereits zum Aufsetzen auf eine Kunststoffträgervorrichtung vorbereiteten biegeplastischen Trägerplatte in Vorderansicht
- Fig.5: ein Detail "X" aus Fig.2
- Fig.6: ein Detail "Y" aus Fig.3
- Fig.7: eine erfindungsgemäße Vorrichtung zur Anordnung von LED-Leuchten mit einer auf einen Kupplungssteg der Kunststoffträgervorrichtung aufsteckbaren Steckvorrichtung

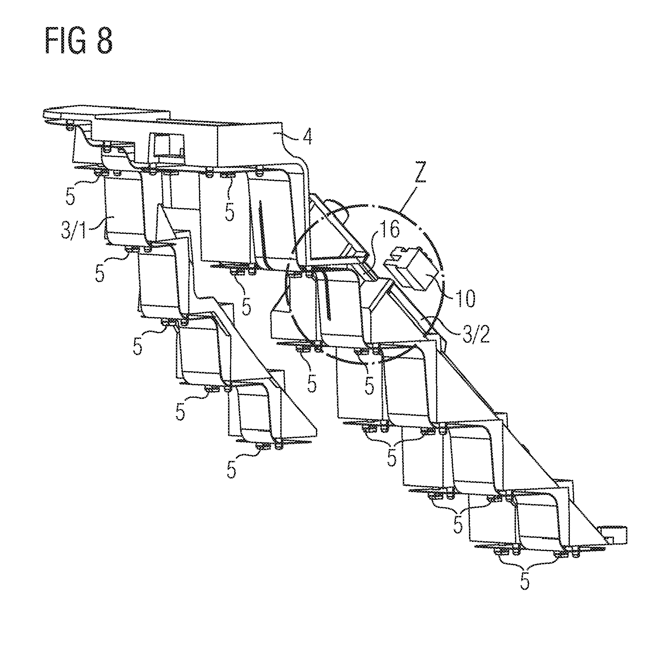

- Fig.8: eine erfindungsgemäße Vorrichtung zur Anordnung von LED-Leuchten mit einer auf einen Kupplungssteg Kunststoffträgervorrichtung aufsteckbaren Steckvorrichtung
- Fig.9: ein Detail "Z" aus Fig.8

### Ausführung der Erfindung

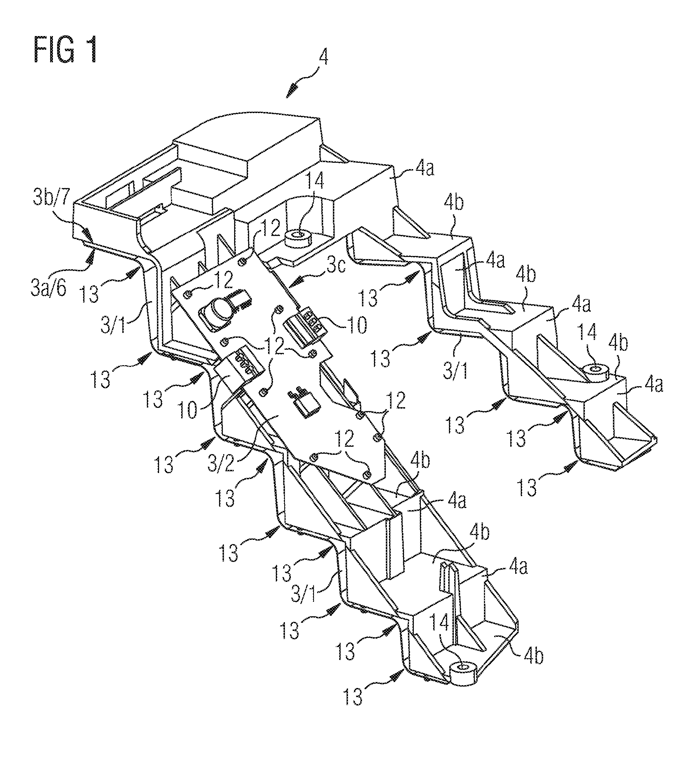

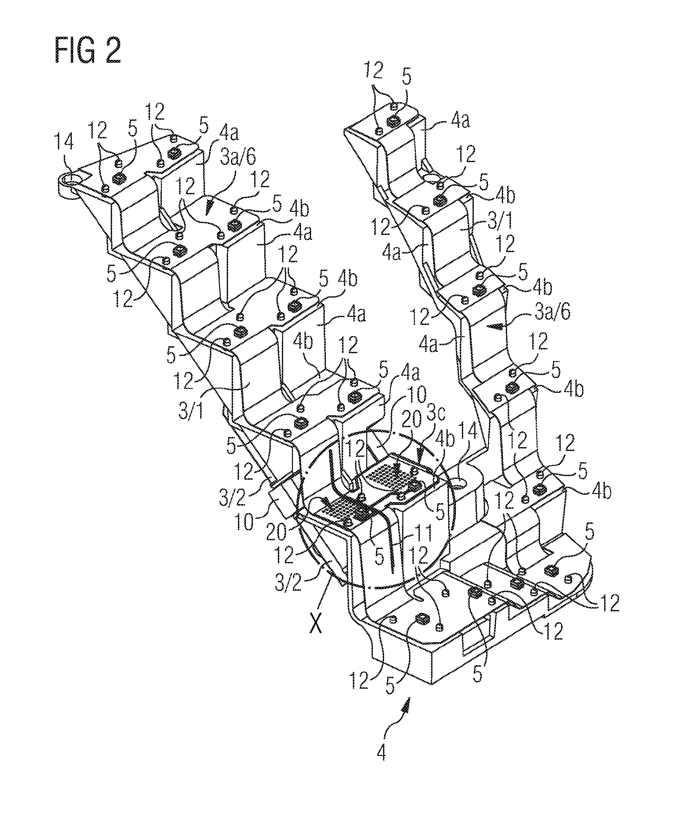

Die Figuren 1 und 2 zeigen eine erfindungsgemäße Vorrichtung zur Anordnung von LED-Leuchten 5 in Vorder- und in Rückansicht. Die erfindungsgemäße Vorrichtung ist im vorliegenden Ausführungsbeispiel zum Einbau in einen Kfz-Rückleuchten-Aufbau vorgesehen, sie kann jedoch ebenso bei Frontscheinwerfern, Blinkern oder anderen Anwendungen zum Einsatz kommen.

Ersichtlich ist eine Kunststoffträgervorrichtung 4 mit vertikalen Stufenabschnitten 4a, horizontalen Stufenabschnitten 4b sowie diversen Verstrebungsabschnitten, wobei sämtliche Abschnitte des Kunststoffträgers 4 einstückig z.B. im Spritzgussverfahren gefertigt sind. Die Abstufung der Kunststoffträgervorrichtung 4 soll eine Anpassung an das Design eines vorgegebenen Gehäuses bzw. einer Linsen- und Reflektoreinrichtung ermöglichen. Selbstverständlich kann die Kunststoffträgervorrichtung 4 eine beliebige dreidimensionale Gestaltung aufweisen und z.B. auch gewölbt sein.

Auf der Kunststoffträgervorrichtung 4 ist in erfindungsgemäßer Weise eine biegeplastische Trägerplatte 3 aus kupferkaschiertem Epoxid-Glashartgewebe angebracht, welche einen Leiterplatten-Abschnitt 1 und einen Steuerplatinen-Abschnitt 2 aufweist, wobei der Leiterplatten-Abschnitt 1 und der Steuerplatinen-Abschnitt 2 mittels eines Verbindungsabschnitts 3c leitend miteinander verbunden sind. Sämtliche Teilabschnitt der biegeplastischen Trägerplatte 3, also sowohl der Leiterplatten-Abschnitt 1 als auch der Steuerplatinen-Abschnitt 2 und der Verbindungsabschnitt 3c sind einstückig gefertigt und weisen eine im Wesentlichen gleiche Querschnittsdicke bzw. einen identischen Schichtaufbau auf.

Der Leiterplatten-Abschnitt 1 der Trägerplatte 3 ist auf einer Vorderseite der Kunststoffträgervorrichtung 4 angeordnet, wobei der an den Leiterplatten-Abschnitt 1 angrenzende Verbindungsabschnitt 3c zweimal um 90°, also insgesamt um 180° umgebogen ist, sodass der Steuerplatinen-Abschnitt 3/2 in platzsparender Weise direkt hinter dem Leiterplatten-Abschnitt 1 auf einer Rückseite der Kunststoffträgervorrichtung 4 platziert werden kann.

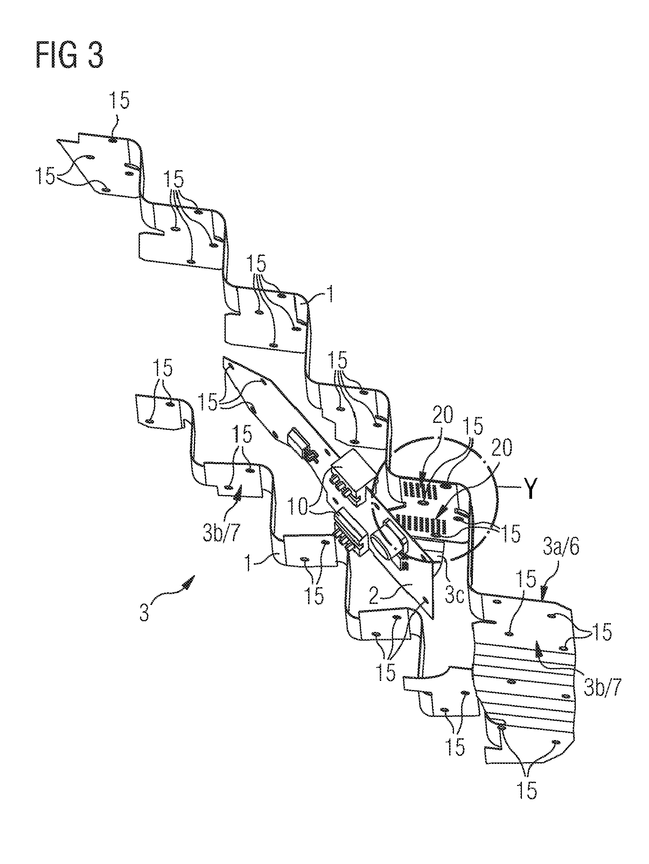

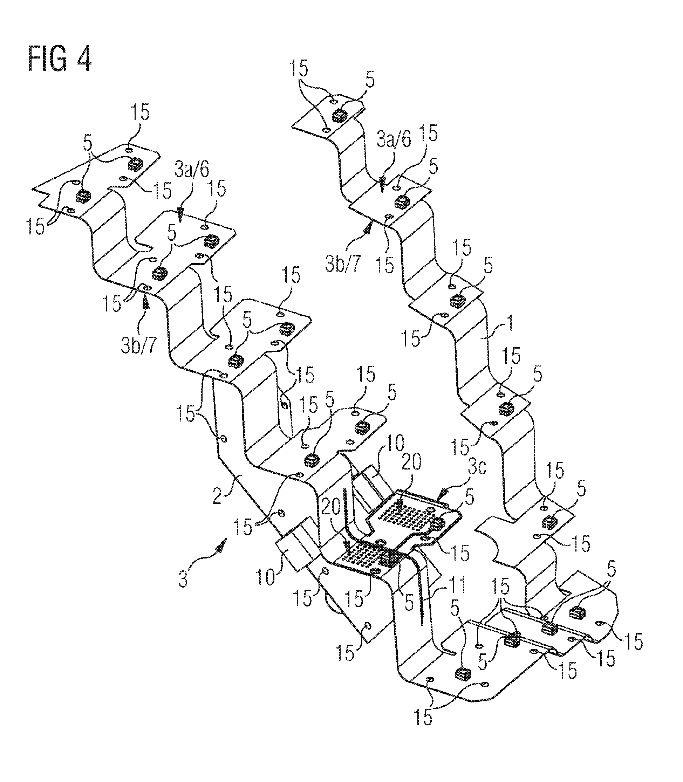

Zum besseren Verständnis sind in den Figuren 3 und 4 isolierte Darstellungen der in der beschriebenen Weise gebogenen erfindungsgemäßen Trägerplatte 3 in Vorder- und Rückansicht gezeigt.

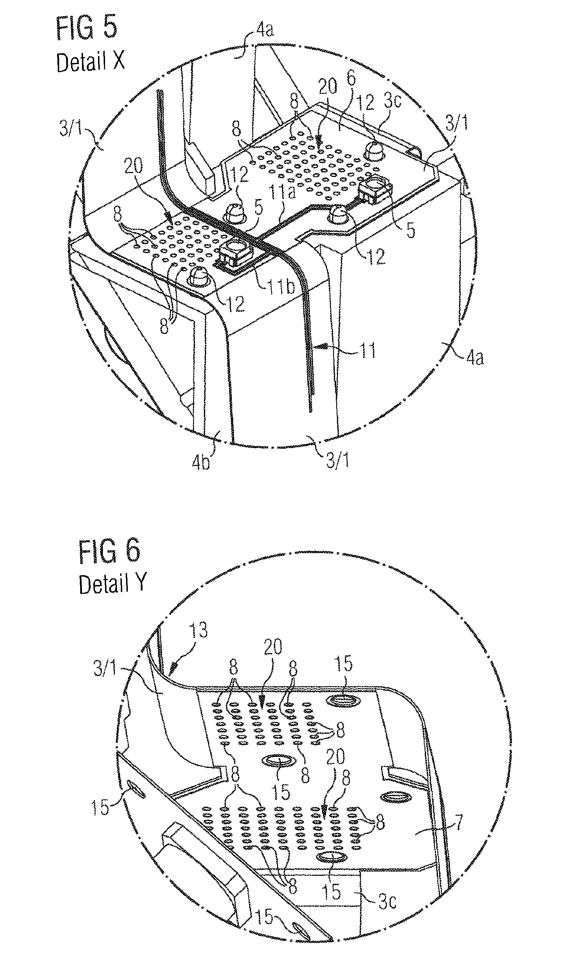

Die biegeplastische Trägerplatte 3 weist eine dielektrische Trägerschicht aus Glasfaser- bzw. Glashartgewebe auf, welche beidseitig mit einer Leiterschicht 6, 7 in Form von Kupferkaschierungen versehen ist. Die Kupferkaschierungen bzw. die Leiterschichten 6, 7 sind in bekannter Weise partiell weggeätzt, um in Fig.1 und Fig.5 rein beispielhaft eingezeichnete Leiterbahnen 11 auszubilden, welche die auf der Trägerplatte 3 angeordneten LED-Leuchten 5 mit elektrischer Energie versorgen.

Die Querschnittsdicke der dielektrischen Trägerschicht der Trägerplatte 3 beträgt zwischen 100 und 150 µm, wobei sich in Versuchen im vorliegenden Anwendungsgebiet eine Querschnittsdicke von 125 µm als ideal hinsichtlich der Plastizitäts- und Festigkeitseigenschaften der Trägerplatte 3 herausgestellt hat.

Theoretisch wäre auch der Einsatz von Teflon-, Aramid- oder anderen Fasern anstelle oder in Kombination mit dem Glashartgewebe zur Ausbildung einer dielektrischen Trägerschicht der Trägerplatte 3 möglich.

Die Grenze der problemlosen Kaltverformbarkeit der biegeplastischen Trägerplatte 3 liegt bei etwa 200 µm. Aus diesem Grund sollte die Querschnittsdicke der Glashart-Trägerschicht der Trägerplatte 3 unter 220 µm liegen.

Die Schichtdicke einer den LED-Leuchten zugewandten oberen Leiterschicht 6 und einer der Kunststoffträgervorrichtung 4 zugewandten unteren Leiterschicht 7 beträgt jeweils etwa 35-70 µm, wobei die aus Kupfer ausgeführten Leiterschichten 6, 7 noch mit zusätzlichen veredelnden Oberflächenschichten wie z.B. Nickel, Gold oder Lötstopplack versehen sein können.

Eine derartige biegeplastische Trägerplatte 3 besitzt im Gegensatz zu konventionell eingesetzten flexiblen Leiterplatten eine ausreichende Starrheit, um ein einfaches und sicheres Bestücken und Verlöten von LED-Leuchten 5 an der Trägerplatte 3 zu ermöglichen. Auf einen Einsatz von Stützrahmen, so wie dies bei einer LED-Bestückung von vergleichsweise weichen flexiblen Leiterplatten erforderlich ist, kann somit verzichtet werden.

Trotz ihrer für eine Bestückung ausreichenden Starrheit ermöglicht die Trägerplatte 3 dennoch ein einfaches und formhaltiges Biegen im Kaltbiegeverfahren, wobei bei einer Einhaltung eines Mindest-Biegeradius von ca. 3 mm Biegewinkel der Trägerplatte 3 von bis zu 120° erzielt werden können. Die in Fig.1 eingezeichneten Biegeradien 13 betragen im vorliegenden Ausführungsbeispiel ca. 4-5 mm.

Wie in den Darstellungen der biegeplastischen Trägerplatte 3 in den Figuren 3 und 4 ersichtlich, können auf diese Weise beliebige Geometrien der Trägerplatte 3 erzeugt werden. Im Gegensatz zu den filmartigen flexiblen Leiterplatten ist somit nach erfolgtem Umformen eine klare Formstabilität der Trägerplatte 3 in einer jeweils gewünschten dreidimensionalen Geometrie gegeben und die vorgeformte Trägerplatte 3 kann auf eine jeweils dafür vorgesehene Kunststoffträgervorrichtung 4 aufgesetzt werden.

Indem der Leiterplatten-Abschnitt 1 und der Steuerplatinen-Abschnitt 2 der Trägerplatte 3 einstückig ausgeführt bzw. mittels eines Verbindungsabschnitts 3c leitend miteinander verbunden sind, entfällt die Vorsehung von Steckern, welche bisher eine separat gefertigte LED-Leiterplatte mit einer eigenständigen Steuerplatine verbunden haben.

Es ist des Weiteren denkbar, in der Trägerschicht bzw. im dielektrischen Glashartgewebe der an der Ober- und Unterseite mit einer Leiterschicht 6, 7 kaschierten Trägerplatte 3 noch eine oder mehrere zusätzliche Leiterschichten vorzusehen, um solcherart eine Multilayer-Leiterplatte auszubilden.

Da es sich bei den LED-Leuchten 5 im vorliegenden Anwendungsgebiet von Kfz-Beleuchtungen um Hochleistungs-LEDs handelt, bedarf es einer effizienten Abführung der durch die LED-Leuchten 5 entwickelten Wärme.

Das Problem der Wärmeabfuhr wird erfindungsgemäß dadurch gelöst, indem der Leiterplatten-Abschnitt 1 der Trägerplatte 3 thermische Areale 20 aufweist, in welchen wärmeableitenden Durchkontaktierungen 8, sogenannte "Thermal Vias", vorgesehen sind. Bei den wärmeableitenden Durchkontaktierungen 8 handelt es sich z.B. um in hexagonaler Rasterform im jeweiligen thermischen Areal 20 angeordnete Kupferzylinder mit einem Durchmesser von < 0,5 mm, wobei der Rasterabstand Durchkontaktierungen 8 ca. 1 mm beträgt.

Indem die Durchkontaktierungen 8 die beiden Leiterschichten 6 und 7 miteinander verbinden, wird ein ausreichender Wärmetransport von der den LED-Leuchten 5 zugewandten oberen Leiterschicht 6 zur der Kunststoffträgervorrichtung 4 zugewandten unteren Leiterschicht 7 ermöglicht (siehe Fig.5 und 6). Auf die bisher praktizierte Vorsehung von Aluminiumplättchen an der der Kunststoffträgervorrichtung 4 zugewandten Leiterplatten-Unterseite 3b kann somit verzichtet werden.

In den Detaildarstellungen gemäß der Figuren 5 und 6 ist ersichtlich, dass die um eine jeweilige LED-Leuchte 5 angeordneten thermischen Areale 20 des Leiterplatten-Abschnitts 1 der Trägerplatte 3 möglichst großflächig ausgestaltet sind, um eine ausreichende Kühlfläche bereitzustellen. Im vorliegenden Ausführungsbeispiel sind die thermischen Areale 20 der Trägerplatte 3 schmetterlingsflügelförmig um die LED-Leuchten 5 angeordnet. Es sei angemerkt, dass sämtliche der in Fig.2 ersichtlichen LED-Leuchten 5 mit derartigen thermischen Arealen 20 bzw. mit rasterförmig angeordneten Durchkontaktierungen 8 versehen sind, obwohl die thermischen Areale 20 lediglich an einer linken unteren Treppenstufe der Kunststoffträgervorrichtung 4 eingezeichnet sind.

Während die Trägerplatte 3 für sich alleine lediglich eine Wärmeleitfähigkeit von 0,2-0,4 W/mK aufweisen würde, so kann im Bereich der durchkontaktierten thermischen Areale 20 eine Wärmeleitfähigkeit von ca. 20 W/mK senkrecht zur Trägerplatte 3 erzielt werden.

Die zu einem "Array" zusammengefassten LED-Leuchten 5 sind matrixförmig in Serien- oder Reihenschaltung am Leiterplatten-Abschnitt 1 der Trägerplatte 3 angeordnet, wobei eine LED-Leuchte 5 im vorliegenden Ausführungsbeispiel vier elektrische Kontakte, nämlich einen Anoden-Fuß und drei Kathoden-Füße aufweist. Im Sinne einer ausreichenden Wärmeabfuhr von den LED-Leuchten 5 ist darauf zu achten, dass die Kathoden-Füße eine gute thermische Anbindung an die obere Leiterschicht 6 aufweisen bzw. möglichst vollflächig mit der oberen Leiterschicht 6 in Verbindung stehen.

Der an die drei Kathoden-Füße angrenzende Bereich der oberen Leiterschicht 6 dient also einerseits der Stromzuführung von einem Bordnetz des Kfz, anderseits auch einer Entwärmung der LED-Leuchten. Es versteht sich, dass die wärmeabführenden Durchkontaktierungen 8 in jenen Bereichen der Trägerplatte 3, in denen die zum Anoden-Fuß der LED-Leuchten 5 führenden Leiterbahnen 11a, 11b verlaufen, ausgespart sind (siehe Fig. 5).

Um einen idealen Wärmeübergang von der unteren Leiterschicht 7 zur Kunststoffträgervorrichtung 4 zu ermöglichen, ist es als weitere erfindungsgemäße Maßnahme vorgesehen, dass die Trägerplatte 3 mittels Anpresselementen 12 an die Kunststoffträgervorrichtung 4 angepresst wird.

Bei diesen Anpresselementen 12 handelt es sich im vorliegenden Ausführungsbeispiel um einstückig mit der Kunststoffträgervorrichtung 4 gefertigte Kunststoffnieten 12, so wie in Fig.5 näher ersichtlich. Hierbei sind jeweils zwei Kunststoffnieten 12 pro LED-Leuchte 5 bzw. pro thermischem Areal 20 vorgesehen, wobei die Kunststoffnieten 12 die Trägerplatte 3 vorzugsweise beiderseits der LED-Leuchte 5 gegen die Kunststoffträgervorrichtung 4 pressen.

Eine in Fig.4 dargestellte, bereits im Kaltbiegeverfahren vorgeformte Trägerplatte 3 wird also auf eine mit Kunststoffniet-Rohlingen versehene Kunststoffträgervorrichtung 4 aufgesetzt, wobei die Trägerplatte 3 korrespondierende Öffnungen 15 aufweist, durch welche die Kunststoffniet-Rohlinge hindurchgeführt werden (siehe auch Fig.6). Anschließend werden die aus der Trägerplatte 3 bzw. aus den Öffnungen 15 hinausragenden Kunststoffniet-Rohlinge z.B. mittels eines thermischen oder eines Ultraschallverfahrens umgeformt bzw. gestaucht, sodass in Fig.5 dargestellte Kunststoffnieten 12 gefertigt werden, deren Nietköpfe einen größeren Durchmesser aufweisen als die Öffnungen 15. Auf diese Weise ist die biegeplastische Trägerplatte 3 solide und ohne Luftspalt an der Kunststoffträgervorrichtung 4 gehalten.

Anstelle von Kunststoffnieten 12 können selbstverständlich auch Klammern, Schrauben, Klebemittel und dgl. zum Einsatz kommen.

Für einfachere LED-Anwendungen, bei denen nur eine geringe Wärmeentwicklung auftritt, reicht es eventuell aus, die Trägerschicht der biegeplastischen Trägerplatte 3 nur mit einer den LED-Leuchten 5 zuweisenden oberen Leiterschicht 6 zu versehen und auf eine untere Leiterschicht 7 zu verzichten. In solchem Falle wird die anfallende Wärme über Strahlung und Konvektion der oberen Leiterschicht 6 an die Umgebung abgeführt.

In einer fortgebildeten Ausführungsweise kann die Kunststoffträgervorrichtung 4 aus wärmeleitendem Kunststoff, z.B. aus mit Al-Oxiden vermengtem Polyamid, gefertigt sein. Auf diese Weise wird eine noch bessere Wärmeabfuhr von den LED-Leuchten 5 erzielt. Hierbei kann je nach Einsatzgebiet bzw. je nach vorliegendem Entwärmungsbedarf eine Auswahl bzw. wärmeleitende Einstellung des Kunststoffs vorgenommen werden.

Die Kunststoffträgervorrichtung 4 weist mehrere in Fig.1 und 2 ersichtliche Befestigungsöffnungen 14 auf, durch welche nicht dargestellte Schraubelemente hindurchführbar sind, um die fertig bestückte Kunststoffträgervorrichtung 4 an einem jeweils dafür vorgesehen Montageort zu befestigen.

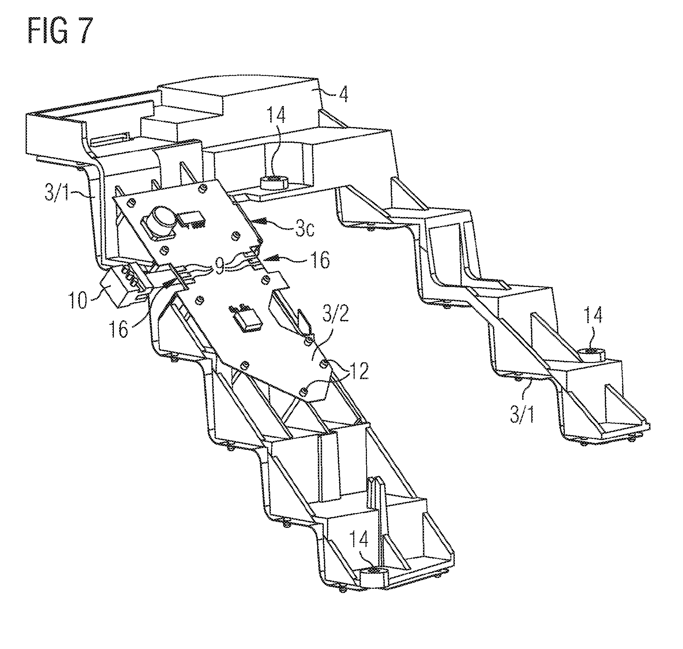

Fig.7 zeigt eine Unteransicht der Kunststoffträgervorrichtung 4 bzw. einen an deren Unterseite befestigten Steuerplatinen-Abschnitt 2 der Trägerplatte 3. Der Steuerplatinen-Abschnitt 2 ist in an sich bekannter Weise mit diversen, nicht näher bezeichneten Elektronikbauteilen bestückt, welche einer Ansteuerung der am Leiterplatten-Abschnitt 1 angeordneten LED-Leuchten, insbesondere einer Begrenzung der Stromstärke der vom Bordnetz gelieferten elektrischen Energie dienen.

Zur Einspeisung der elektrischen Energie des Bordnetzes ist der Steuerplatinen-Abschnitt 2 der Trägerplatte 3 mit Kontaktbahnen 9 versehen, welche mit korrespondierenden (in der vorliegenden Perspektive nicht sichtbaren) Kontakten von Steckvorrichtungen 10 in Verbindung bringbar sind.

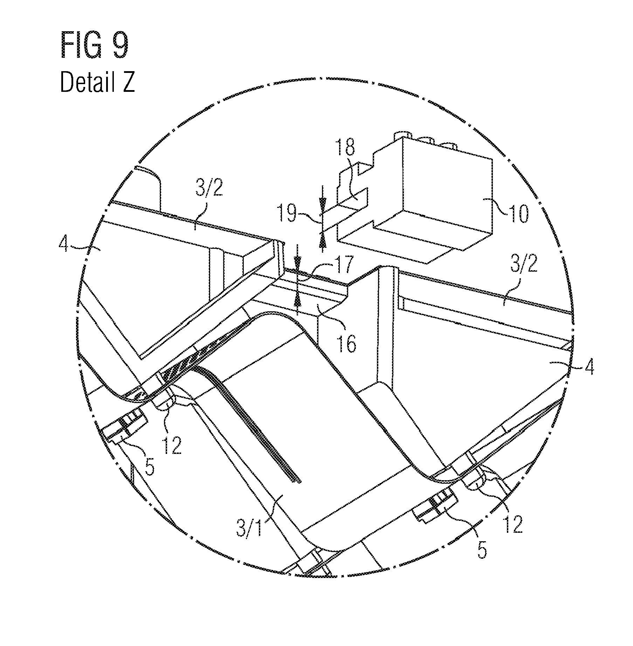

Um ein problemloses Aufstecken der Steckvorrichtungen 10 auf den Steuerplatinen-Abschnitt 2 zu ermöglichen, weist die Kunststoffträgervorrichtung 4 erfindungsgemäß einen Kupplungssteg 16 auf, dessen Stegdicke 17 in Addition mit einer Querschnittsdicke der am Kupplungssteg 16 aufliegenden Trägerplatte 3 samt der Schichtdicke der daran angeordneten Kontaktbahnen 9 im Wesentlichen einer lichten Breite 19 einer Steckeraufnahme 18 der Steckvorrichtung 10 entspricht (siehe Fig.9). Genauer gesagt, ist zwischen dem Kupplungssteg 16 und der Steckeraufnahme 18 eine Presspassung ausgebildet, sodass das Maß der lichten Breite 19 der Steckeraufnahme 18 geringfügig kleiner ist als das Maß der Kupplungsstegdicke 17.

Die biegeplastische Trägerplatte 3 ist also im Bereich der Kontaktbahnen 9 mit einem vom Kupplungssteg 16 ausgebildeten Trägermaterial "unterfüttert", welches der Trägerplatte 3 in jenem Bereich eine ausreichende Stabilität verleiht, um mit der Steckvorrichtung 10 zuverlässig gekuppelt zu werden.

### Bezugszeichenliste

- 1: Leiterplattenabschnitt 3/1
- 2: Steuerplatinenabschnitt 3/2
- 3: Trägerplatte, 3c Verbindungsabschnitt
- 4: Kunststoffträgervorrichtung 4a vertikal, 4b horizontal
- 5: LED
- 6: Leiterschicht
- 7: Leiterschicht
- 8: Durchkontaktierung (Wärme)
- 9: Kontaktbahn
- 10: Steckvorrichtung
- 11: Leiterbahn
- 12: Anpresselement, Kunststoffniete
- 13: Biegeradius
- 14: Befestigungsöffnung
- 15: Öffnung
- 16: Kupplungssteg
- 17: Stegdicke
- 18: Steckeraufnahme
- 19: lichte Breite
- 20: Areale (Wärme)

## Patentansprüche

1. Vorrichtung zur Anordnung von LED-Leuchten (5), umfassend eine Leiterplatte (1) und eine auf dieser anordenbare beliebige Anzahl an LED-Leuchten (5) sowie eine mit der Leiterplatte (1) in Verbindung stehende Steuerplatine (2), wobei die Leiterplatte (1) und die Steuerplatine (2) auf einer Kunststoffträgervorrichtung (4) angebracht sind und die Steuerplatine (2) über eine Steckvorrichtung (10) an eine elektrische Energiequelle angeschlossen ist, **dadurch gekennzeichnet, dass** die Leiterplatte (1) einstückig mit der Steuerplatine (2) gefertigt und als biegeplastische Trägerplatte (3), vorzugsweise aus kupferkaschiertem Epoxid-Glashartgewebe ausgeführt ist.

2. Vorrichtung nach Anspruch 1, **dadurch gekennzeichnet, dass** die Trägerplatte (3) nur auf ihrer in Montagelage den LED-Leuchten (5) zugewandten Oberseite (3a) mit einer Leiterschicht (6) versehen ist.

3. Vorrichtung nach Anspruch 1, **dadurch gekenn zeichnet, dass** die Trägerplatte (3) sowohl an ihrer in Montagelage den LED-Leuchten (5) zugewandten Oberseite (3a) als auch an ihrer in Montagelage der Kunststoffträgervorrichtung (4) zugewandten Unterseite (3b) mit einer Leiterschicht (6, 7) versehen ist, wobei die Trägerplatte (3) in thermischen Arealen (20) mit wärmeableitenden Durchkontaktierungen (8) versehen ist, welche die beiden Leiterschichten (6, 7) miteinander verbinden.

4. Vorrichtung nach einem der Ansprüche 1 bis 3, **dadurch gekennzeichnet, dass** die Trägerplatte (3) mittels Anpresselementen (12) an die Kunststoffträgervorrichtung (4) angepresst wird.

5. Vorrichtung nach Anspruch 4, **dadurch gekenn -zeichnet, dass** die Anpresselemente (12) Kunststoffnieten (12) sind, welche vorzugsweise einstückig mit der Kunststoffträgervorrichtung (4) gefertigt sind.

6. Vorrichtung nach einem der Ansprüche 1 bis 5, **dadurch gekennzeichnet, dass** die Kunststoffträgervorrichtung (4) aus wärmeleitendem Kunststoff gefertigt ist.

7. Vorrichtung nach einem der Ansprüche 1 bis 6, **dadurch gekennzeichnet, dass** die Kunststoffträgervorrichtung (4) einen Kupplungssteg (16) aufweist, dessen Stegdicke (17) in Addition mit einer Querschnittsdicke der am Kupplungssteg (16) aufliegenden Trägerplatte (3) samt daran angeordneter Kontaktbahnen (9) im Wesentlichen einer lichten Breite (19) einer Steckeraufnahme (18) der Steckvorrichtung (10) entspricht.

8. Vorrichtung nach einem der Ansprüche 1 bis 7, **dadurch gekennzeichnet, dass** ein mit LED-Leuchten bestückter Leiterplatten-Abschnitt (3/1) der Trägerplatte (3) auf einer Vorderseite der Kunststoffträgervorrichtung (4) angeordnet ist und ein Steuerplatinen-Abschnitt (3/2) der Trägerplatte (3) auf einer Rückseite der Kunststoffträgervorrichtung (4) angeordnet ist, wobei der Leiterplatten-Abschnitt (3/1) und der Steuerplatinen-Abschnitt (3/2) mittels eines einstückig mit jenen Abschnitten (3/1, 3/2) gefertigten und im Wesentlichen um 180° umgebogenen Verbindungsabschnitts (3c) miteinander verbunden sind.

9. Vorrichtung nach einem der Ansprüche 1 bis 8, **dadurch gekennzeichnet, dass** die Querschnittsdicke einer aus Glashartgewebe bestehenden dielektrischen Trägerschicht der Trägerplatte (3) < 220 µm ist.

10. Vorrichtung nach Anspruch 9, **dadurch gekenn zeichnet**, **dass** die Querschnittsdicke der dielektrischen Trägerschicht der Trägerplatte (3) zwischen 100 und 150 µm beträgt.
